## Europäisches Patentamt
## European Patent Office
## Office européen des brevets

(11) Veröffentlichungsnummer: **0 111 181**
**B1**

(12) **EUROPÄISCHE PATENTSCHRIFT**

(45) Veröffentlichungstag der Patentschrift: **27.06.90**

(21) Anmeldenummer: **83111368.3**

(22) Anmeldetag: **14.11.83**

(51) Int. Cl.⁵: **H 01 L 23/48**, H 01 L 29/40

(54) **Halbleiterbauelement mit Kontaktloch.**

(30) Priorität: **08.12.82 DE 3245457**

(43) Veröffentlichungstag der Anmeldung:
**20.06.84 Patentblatt 84/25**

(45) Bekanntmachung des Hinweises auf die
Patenterteilung:
**27.06.90 Patentblatt 90/26**

(84) Benannte Vertragsstaaten:
**CH DE FR GB IT LI**

(56) Entgegenhaltungen:
**EP-A-0 022 280**
**EP-A-0 038 994**
**FR-A-2 362 492**
**FR-A-2 371 779**
**US-A-3 969 745**
**US-A-4 194 933**
**US-A-4 200 968**

(73) Patentinhaber: **Siemens Aktiengesellschaft**
**Wittelsbacherplatz 2**
**D-8000 München 2 (DE)**

(72) Erfinder: **Strack, Helmut, Dr. phil.**
**Speyererstrasse 6**
**D-8000 München 40 (DE)**
Erfinder: **Schuh, Gottfried**
**Lutzstrasse 16**
**D-8900 Augsburg (DE)**

Courier Press, Leamington Spa, England.

## Beschreibung

Die Erfindung bezieht sich auf ein Halbleiterbauelement mit den Merkmalen:

a) Ein Halbleitersubstrat enthält eine erste Zone vom ersten Leitungstyp,

b) über der ersten Zone liegt eine zweite Zone vom zweiten Leitungstyp,

c) die zweite Zone ist mit einer Öffnung versehen,

d) die erste Zone hat unter der Öffnung eine Vertiefung,

e) die erste und die zweite Zone sind durch eine leitende Schicht elektrisch miteinander verbunden,

f) die leitende Schicht kontaktiert die erste Zone in der Vertiefung und die zweite Zone an der Wand der Öffnung,

g) die Vertiefung hat einen ebenen, zur Oberfläche des Halbleitersubstrats parallelen Boden,

h) die zweite Zone hat eine Dotierungskonzentration von $\geq 10^{19} cm^{-3}$.

Ein solches Halbleiterbauelement ist beispielsweise in der EP—A2 38 994 beschrieben worden. Dieses Halbleiterbauelement hat einen Sourcekontakt, der die an der Oberfläche des Substrats liegende Sourcezone über eine höher als die Sourcezone dotierte Hilfszone kontaktiert. Die Hilfszone hat eine Öffnung, in der die erste Zone ebenfalls durch den Sourcekontakt kontaktiert wird. Dieser Kontakt benötigt eine relativ große Fläche.

Der Erfindung liegt die Aufgabe zugrunde, ein Halbleiterbauelement der beschriebenen Gattung so weiterzubilden, daß der Kontakt flächensparender ausgebildet werden kann.

Die Erfindung ist gekennzeichnet durch die Merkmale:

i) Die erste Zone weist in der Nähe und senkrecht zur Substratoberfläche ein Konzentrationsmaximum an Dotierstoffen auf,

j) der Boden der Vertiefung liegt wenigstens annähernd in der Tiefe des Konzentrationsmaxiums.

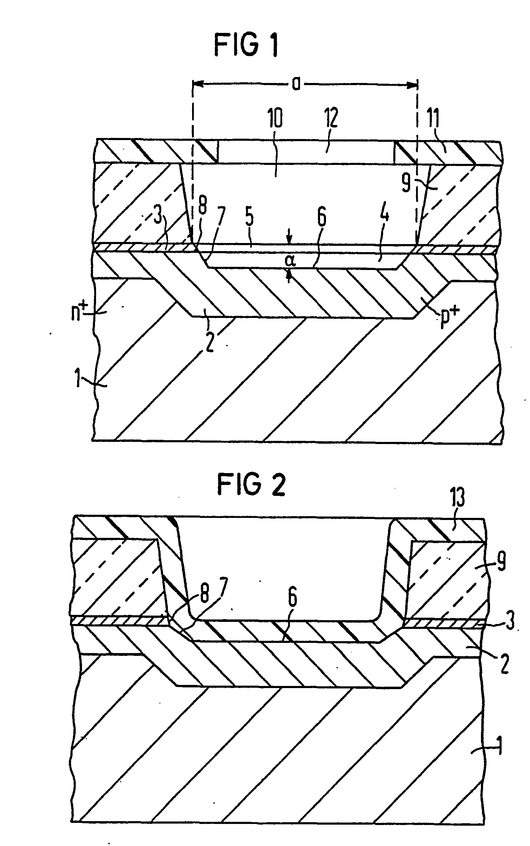

Die Erfindung wird anhand eines Ausführungsbeispiels in Verbindung mit den Figuren 1 und 2 näher erläutert:

Das Halbleiterbauelement weist ein Halbleitersubstrat 1 auf, das eine erste Zone 2 vom ersten Leitungstyp enthält. Die Zone kann beispielsweise stark p-dotiert sein. Über der ersten Zone 2 liegt eine zweite Zone 3 des entgegengesetzten Leitungstyps, im Ausführungsbeispiel ist sie stark n-dotiert. Die erste Zone 2 hat eine Vertiefung 4, während die zweite Zone 3 mit einer Öffnung 5 mit im wesentlichen gleicher Querschnittsfläche wie die Vertiefung versehen ist. Die Vertiefung 4 ist durch einen zur Oberfläche des Substrats parallelen Boden 6 und durch Seitenwände 7 begrenzt. Die Öffnung 5 ist durch Seitenwände 8 begrenzt. Über der zweiten Zone 3 liegt eine Isolierschicht 9, die beispielsweise aus Siliciumdioxid besteht. Diese Isolierschicht ist mit einer Öffnung 10 versehen.

Die erste Zone 2 kann z.B. durch Ionenimplantation mit anschließender Eindiffusion hergestellt sein. Die Ionenimplantation wie auch die Diffusion erzeugt ein Maximum der Dotierstoffkonzentration in der Nähe der Oberfläche des Substrats. Die Tiefe des Bodens 6 der Öffnung 4 gemessen von der Oberfläche des Substrats liegt nun wenigstens annähernd in der Tiefe des Dotierungsmaximums. Unter anganähert soll hierbei eine maximale Abweichung von $-20\%$ der maximalen Dotierstoffkonzentration verstanden werden. Das Dotierungsmaximum und damit die Tiefe liegt bei einer Ionenimplantation abhängig von der Energie der implantierten Ionen in der Regel unter 1 μm, z.B. bei 0,5 μm. Dieses Maximum kann bei etwa $10^{18}$ Atomen $cm^{-3}$ liegen.

Die zweite Zone 3 wird zweckmäßigerweise ebenfalls durch eine Ionenimplantation hergestellt. Die Dicke dieser Zone kann unter 0,5 μm, z.B. bei 0,2 μm, liegen. Zur Erzielung eines guten Kontakts und einer guten elektrischen Verbindung zwischen den Zonen 2 und 3 liegt die Dotierung der Zone 3 bei mindestens $10^{19}$, z.B. bei $2 \cdot 10^{20}$ Atomen $cm^{-3}$. Zur Vergrößerung der Kontaktfläche der Zone 3 können sich ihre Seitenwände 8 wie gezeigt zum Substrat trichterförmig verengen.

Die in Fig. 1 gezeigt Struktur kann wie folgt hergestellt werden:

Auf die ganzflächigen Zonen 2, 3 und die ganzflächige Isolierschicht 9 wird eine Fotolackschicht 11 aufgebracht, in der auf bekannte Weise eine Öffnung 12 erzeugt wird. Diese Öffnung 12 ist kleiner als die beabsichtigte Breite a des Kontakts. Dann wird zuerst die Öffnung 10 in der Isolierschicht 9 durch Plasma- oder Naßätzen hergestellt. Die Öffnung 5 in der Zone 3 und die Vertiefung 4 in der Zone 2 werden auf bekannte Weise durch Plasmaätzen erzeugt. Bei beiden Ätzvorgängen sorgt der Überstand der Lackmaske 11 für einen schrägen Verlauf der Wände in den geätzten Schichten und verhindert ein Unterätzen der Zonen 2 und 3.

Nach Entfernen der Fotomaske 11 wird auf der Oberfläche des Halbleiterbauelements eine leitende Schicht 13, z.B. aus Aluminium, niedergeschlagen (Fig. 2). Diese Schicht kontaktiert die Zone 3 an ihren Seitenwänden 8 und die Zone 2 am Boden 6 und den Seitenwänden 7. Hierdurch sind beide Zonen elektrisch angeschlossen und elektrisch miteinander elektrisch verbunden. Durch die Schräge der Seitenwand 7 der Vertiefung in der zweiten Zone 2 werden kleine Krümmungsradien für die leitende Schicht 13 vermieden. Der beschriebene Kontakt kann sehr platzsparend ausgebildet werden.

## Patentansprüche

1. Halbleiterbauelement mit den Merkmalen:

a) Ein Halbleitersubstrat (1) enthält eine erste Zone (2) vom ersten Leitungstyp,

b) über der ersten Zone (2) liegt eine zweite Zone (3) vom zweiten Leitungstyp,

c) die zweite Zone (3) ist mit einer Öffnung (5) versehen,

d) die erste Zone (2) hat unter der Öffnung (5) eine Vertiefung (4),

e) die erste und die zweite Zone sind durch eine leitende Schicht (13) elektrisch miteinander verbunden,

f) die leitende Schicht (13) kontaktiert die erste Zone (2) in der Vertiefung (4) und die zweite Zone (3) an der Wand (8) der Öffnung (5),

g) die Vertiefung (4) hat einen ebenen, zur Oberfläche des Halbleitersubstrats parallelen Boden (6),

h) die zweite Zone (3) hat eine Dotierungskonzentration von $\geq 10^{19} cm^{-3}$, gekennzeichnet durch die Merkmale:

i) die erste Zone (2) weist in der Nähe und senkrecht zur Substratoberfläche ein Konzentrationsmaximum an Dotierstoffen auf,

j) der Boden (6) der Vertiefung (4) liegt wenigstens annähernd in der Tiefe des Konzentrationsmaximums.

2. Halbleiterbauelement nach Anspruch 1, dadurch gekennzeichnet, daß sich die Öffnung (5) der zweiten Zone (3) in Richtung zum Substrat (1) trichterförmig verengt.

3. Halbleiterbauelement nach Anspruch 1 oder 2, dadurch gekennzeichnet, daß die zweite Zone (3) an der Oberfläche von einer Isolierschicht (9) bedeckt ist.

4. Halbleiterbauelement nach Anspruch 3, dadurch gekennzeichnet, daß die Isolierschicht (9) über der Öffnung (5) der zweiten Zone (3) ihrerseits eine Öffnung (10) aufweist, und daß sich die Öffnung (10) der Isolierschicht (9) zur zweiten Zone (3) hin trichterförmig verengt.

5. Verfahren zum Herstellen eines Halbleiterbauelements nach einem der Ansprüche 1 bis 4, dadurch gekennzeichnet, daß im Halbleitersubstrat die erste (2) und darauf die zweite Zone (3) erzeugt werden, daß auf der zweiten Zone eine Isolierschicht (9) aufgebracht wird, daß auf die Isolierschicht eine Fotomaske (11) aufgebracht wird, daß die Fotomaske mit einer Öffnung (12) versehen wird, die kleiner ist als die herzustellenden Öffnungen in der Isolierschicht und in der zweiten Zone, und daß die Öffnung in der Isolierschicht durch Plasma- oder Naßätzen und die Öffnung in der zweiten Zone sowie die Vertiefung in der ersten Zone durch Plasmaätzen erzeugt wird, derart daß der Boden der Vertiefung (4) wenigstens annähernd in der Tiefe des Konzentrationsmaximums liegt, daß dann die Fotomaske entfernt und auf die Oberfläche des Halbleiterbauelements eine leitende Schicht (13) aufgebracht wird, die den Boden der Vertiefung (4) kontaktiert.

**Revendications**

1. Composant à semiconducteurs présentant les caractéristiques suivantes:

a) un substrat semiconducteur (1) qui contient une première zone (2) possédant le premier type de conductivité,

b) une seconde zone (3) possédant le second type de conductivité est située au-dessus de la première zone (2),

c) la seconde zone (3) comporte une ouverture (5),

d) la première zone (2) possède un renfoncement (4) sous l'ouverture (5),

e) les première et seconde zones sont reliées électriquement entre elles par une couche conductrice (13),

f) la couche conductrice (13) est en contact avec la première zone (2) située dans le renfoncement et avec la seconde zone (3) située contre la paroi (8) de l'ouverture (5),

g) le renfoncement (4) possède un fond plat (6), parallèle à la surface du substrat semiconducteur,

h) la seconde zone (3) possède une concentration de dopage $\geq 10^{19} cm^{-3}$, caractérisé par les moyens particuliers suivants:

i) la première zone (2) possède, à proximité de la surface du substrat et perpendiculairement à cette dernière, un maximum de concentration en substance dopante,

j) le fond (6) du renfoncement (4) est situé au moins approximativement à la profondeur du maximum de concentration.

2. Composant à semiconducteurs suivant la revendication 1, caractérisé par le fait que l'ouverture (5) de la seconde zone (3) se rétrécit avec une forme d'entonnoir en direction du substrat (1).

3. Composant à semiconducteurs suivant la revendication 1 ou 2, caractérisé par le fait que la seconde zone (3) est recouverte, au niveau de la surface, par une couche isolante (9).

4. Composant à semiconducteurs suivant la revendication 3, caractérisé par le fait que la couche isolante (9) comporte pour sa part, au-dessus de l'ouverture (5) de la seconde zone (3), une ouverture (10), et que l'ouverture 10) de la couche isolante (9) se rétrécit avec une forme d'entonnoir en direction de la seconde zone (3).

5. Procédé par fabriquer un composant semi-conducteur suivant l'une des revendications 1 à 4, caractérisé par le fait qu'on forme, dans le substrat à semiconducteurs, la première couche (2) et, sur cette dernière, la seconde couche (3), qu'on dépose une couche isolante (9) sur la seconde zone, qu'on dépose un photomasque (11) sur la couche isolante, qu'on ménage dans le photomasque une ouverture (12) plus petite que les ouvertures devant être ménagées dans la couche isolante et dans la seconde zone, et qu'on ménage l'ouverture dans la couche isolante au moyen d'une corrosion plasmatique ou d'une corrosion par voie humide et qu'on ménage l'ouverture dans la seconde zone ainsi que le renfoncement dans la première zone au moyen d'une corrosion plasmatique, de sorte que le premier renfoncement (4) est situé au moins approximativement à la profondeur du maximum de concentration, qu'on élimine ensuite le photomasque et qu'on dépose sur la surface du composant à semiconducteurs une couche isolante (13), qui est en contact avec le fond du renfoncement (4).

**Claims**

1. Semiconductor component with the features:

a) a semiconductor substrate (1) contains a first zone (2) of the first conductor type,

b) a second zone (3) of the second conductor type lies over the first zone (2),

c) the second zone (3) is provided with an opening (5),

d) the first zone (2) has a depression (4) below the opening (5),

e) the first and the second zone are connected electrically to one another via a conductive layer (13),

f) the conductive layer (13) makes contact with the first zone (2) in the depression (4) and with the second zone (3) at the wall (8) of the opening (5),

g) the depression (4) has a level floor (6) parallel to the surface of the semiconductor substrate (6),

h) the second zone (3) has a doping concentration of $\geq 10^{19} cm^{-3}$, characterized by the features:

i) the first zone (2) has a maximum concentration of doping substances in the vicinity of and perpendicular to the substrate surface,

j) the floor (6) of the depression (4) lies at least approximately in the deepest part of the maximum concentration.

2. Semiconductor component according to Claim 1, charcterized in that the opening (5) of the second zone (3) tapers in a funnel-shaped manner in the direction of the substrate (1).

3. Semiconductor component according to Claim 1 or 2, characterized in that the second zone (3) is covered on the surface by an insulating layer (9).

4. Semiconductor component according to Claim 3, characterized in that the insulating layer (9) over the opening (5) of the second zone (3) has, itself, an opening (10), and in that the opening (10) of the insulating layer (9) tapers towards the second zone (3) in a funnel-shaped manner.

5. Method for manufacturing a semiconductor component according to one of Claims 1 to 4, characterized in that the first zone (2) and, on top of it, the second zone (3) are produced in the semiconductor substrate, in that an insulating layer (9) is applied to the second zone, in that a photomask (11) is applied to the insulating layer, in that the photomask is provided with an opening (12) which is smaller than the openings to be made in the insulating layer and in the second zone, and in that the opening in the insulating layer is produced by plasma or wet etching and the opening in the second zone as well as the depression in the first zone are generated by plasma etching in such a way that the floor of the depression (4) lies at least approximately in the deepest part of the maximum concentration, in that the photomask is then removed and a conductive layer (13) is then applied to the surface of the semiconductor component, which conductive layer then makes contact with the floor of the depression (4).

# FIG 1

# FIG 2